# DEMANDE DE BREVET EUROPEEN

(11) **EP 4 561 294 A1**
(43) Date de publication de la demande: **28.05.2025**
(21) Numéro de dépôt: 24213651.3
(22) Date de dépôt: 18.11.2024
(51) Int. Cl.: H10D 48/32, H10D 48/01, H10D 30/01, H10D 30/40, H10D 62/10, H10D 62/81, H10D 64/27, H10D 48/00, B82Y 10/00

(54) **DISPOSITIF QUANTIQUE À MATRICE BIDIMENSIONNELLE ET SON PROCÉDÉ DE RÉALISATION**

(30) Priorité: 21.11.2023 FR 2312825
(71) Demandeur: Commissariat à l'Energie Atomique et aux Energies Alternatives, 75015 Paris (FR)
(72) Inventeur: BERTRAND, Benoit, 38054 GRENOBLE Cedex 09 (FR)
(74) Mandataire: Hautier IP

(57) **Abrégé**

L'invention porte sur un dispositif quantique comprenant :
• une pluralité de boites quantiques arrangées dans une couche semiconductrice (12) en matrice bidimensionnelle;
• un premier ensemble de grilles (200) de contrôle des boîtes quantiques, surmontant la pluralité de boites quantiques formée dans la couche semi-conductrice,
• un deuxième ensemble de grilles (600) surmontant le premier ensemble de grilles (200),
• une pluralité de détecteurs (4, 4a, 4'a, 4b, 4'b) de charge, entre les grilles du premier ensemble de grilles et au-dessus de la couche semi-conductrce, couplés capacitivement aux boites quantiques (120),

Avantageusement, la pluralité de détecteurs (4, 4a, 4'a, 4b, 4'b) de charge est intégrée dans l'un parmi les premier et deuxième ensemble de grilles, chaque détecteur de charge comprenant une portion (400, 400a, 400b) située entre les grilles (200, 600) de l'ensemble de grilles considéré.

L'invention porte également sur un procédé de réalisation d'un tel dispositif quantique.

## Description

### DOMAINE TECHNIQUE

La présente invention concerne le domaine de la microélectronique et de l'électronique quantique en particulier. Elle trouve pour application particulièrement avantageuse la réalisation de matrices bidimensionnelles de dispositifs à bits quantiques (appelés quantum bits ou qubits) intégrant un système de détection de charge compact.

### ETAT DE LA TECHNIQUE

Le domaine technique est celui de l'information quantique. Les bits d'information appelés qubits sont ici réalisés dans des boîtes quantiques qui assurent le confinement de charges élémentaires (électrons ou trous). L'information quantique est, par exemple, codée sur le spin de ces particules.

Pour coder et manipuler l'information contenue dans les boites quantiques, par exemple pour initialiser une boite quantique avec une charge unique, il est généralement nécessaire de connaître le nombre de charges présentes dans la ou les boites quantiques. Une solution pour connaître ce nombre de charges consiste à disposer un détecteur de charge à proximité des boites quantiques.

Le fonctionnement d'un tel détecteur de charge repose sur un couplage capacitif avec la boite quantique. Il est donc avantageux de minimiser la distance entre le détecteur et la boite quantique pour augmenter la sensibilité du détecteur. L'environnement de la boite quantique comprend également les éléments de contrôle des qubits, typiquement des grilles de contrôle. L'encombrement et la sensibilité du détecteur sont donc des aspects importants d'un dispositif à bits quantiques.

Les détecteurs de charge basés sur un élément conducteur relié à un ou plusieurs réservoirs de charge, tels que les transistors à électrons uniques (SET) ou les points quantiques à simple réservoir (SLQD), sont parmi les détecteurs les plus efficaces et les plus sensibles. Ils permettent notamment une lecture absolue du nombre de charges dans une boite quantique.

Ce type de détecteur de charge nécessite néanmoins une ou plusieurs grilles de polarisation pour fonctionner ainsi que un ou plusieurs réservoirs de porteurs. Cela augmente considérablement l'encombrement de ce type de détecteur.

Pour des réseaux unidimensionnels (1D) de boites quantiques, les détecteurs de charge de type SET peuvent être intégrés dans le même plan que les boites quantiques, en regard de celles-ci.

Pour des réseaux bidimensionnels (2D) de boites quantiques, l'encombrement des détecteurs de type SET limite les possibilités d'intégration de ces détecteurs à proximité des boites quantiques.

Selon une possibilité divulguée par exemple dans le document « Shared control of a 16 semiconductor quantum dot crossbar array, F. Borsoi et al., Condensed Matter, 2022 », les détecteurs sont intégrés en périphérie des boites quantiques. Cela limite la taille des matrices 2D à quelques boites quantiques par côté.

Selon une autre possibilité divulguée dans le document FR3066297, les détecteurs de type SET sont intégrés dans un premier plan situé sous un deuxième plan comprenant les boites quantiques. Ces premier et deuxième plans sont séparés par au moins un niveau comprenant les grilles de polarisation des détecteurs, et des interconnexions entre les détecteurs et les boites quantiques. Le deuxième plan comprenant les boites quantiques est également surmonté par des niveaux de grilles de contrôle des boites quantiques. Une telle architecture est très complexe à réaliser.

Par ailleurs, les contraintes de fabrication limitent la proximité des détecteurs à environ 100 nm ou plus des boites quantiques à détecter.

Les grilles de contrôle et/ou de polarisation peuvent également écranter partiellement les boites quantiques pour les détecteurs, ce qui réduit l'intensité du couplage capacitif et la sensibilité du détecteur.

Il existe donc un besoin relatif à un dispositif quantique à matrice bidimensionnelle (2D) de boites quantiques comprenant des détecteurs de charge moins encombrants et/ou mieux intégrés. Un objectif de l'invention est de répondre à ce besoin, et de pallier au moins en partie les inconvénients des solutions connues.

En particulier, un objet de l'invention est un dispositif quantique comprenant des détecteurs de charge présentant une compacité améliorée. Un autre objet de l'invention est un procédé de réalisation d'un tel dispositif.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un dispositif quantique comprenant :
- une couche semi-conductrice dans laquelle est formée, lors du fonctionnement du dispositif quantique, une pluralité de boites quantiques arrangées en matrice bidimensionnelle,
- une pluralité de détecteurs de charge couplés capacitivement aux boites quantiques de la pluralité de boites quantiques
- un premier ensemble de grilles comprenant des grilles de contrôle des boites quantiques, surmontant la couche semi-conductrice,
- un deuxième ensemble de grilles comprenant des grilles destinées à former au moins un réservoir de charges pour les détecteurs de charge.

Avantageusement, chaque détecteur de charge comprend une portion située entre les grilles du premier ensemble de grilles. De préférence, les grilles du deuxième ensemble de grilles forment un unique réservoir de charge commun à chaque détecteur de charge.

Ainsi, contrairement à la solution divulguée par le document FR3066297 dans laquelle les détecteurs de charge sont disposés sur un niveau distinct et séparé des niveaux de grilles de contrôle des boites quantiques, le dispositif selon l'invention intègre les détecteurs directement au sein des niveaux de grilles de contrôle des boites quantiques. Cela permet d'améliorer la compacité du dispositif. Les détecteurs peuvent en outre être plus proches des boites quantiques. L'architecture de dispositif proposée par la présente invention est également moins complexe à réaliser par les procédés technologiques standards de la microélectronique.

Un autre aspect de l'invention concerne un procédé de réalisation d'un tel dispositif quantique, comprenant :
- une formation d'une couche semi-conductrice destinée à comprendre une pluralité de boites quantiques arrangées en matrice bidimensionnelle,
- une formation d'un premier ensemble de grilles comprenant des grilles de contrôle des boites quantiques, surmontant la couche semi-conductrice,
- une formation d'un deuxième ensemble de grilles comprenant des grilles destinées à former au moins un réservoir de charges pour des détecteurs (4, 4a, 4'a, 4b, 4'b) de charge,
- une formation d'une pluralité de détecteurs de charge couplés capacitivement aux boites quantiques de la pluralité de boites quantiques, ladite formation étant configurée de sorte que chaque détecteur de charge comprenne une portion située entre les grilles du premier ensemble de grilles.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures nA (n=1...11) illustrent schématiquement en coupe transverse des étapes de fabrication d'un dispositif quantique, selon un mode de réalisation de la présente invention.
Les figures nB (n=1...11) illustrent schématiquement en vue de dessus les étapes de fabrication illustrées aux figures nA correspondantes, selon un mode de réalisation de la présente invention.
La figure 10C illustre en perspective l'étape de fabrication du dispositif quantique illustrée aux figures 10A et 10B, selon un mode de réalisation de la présente invention.
La figure 12 illustre schématiquement en coupe transverse un dispositif quantique, selon un premier mode de réalisation de la présente invention.
La figure 13 illustre schématiquement en coupe transverse un dispositif quantique, selon un deuxième mode de réalisation de la présente invention.
La figure 14 illustre schématiquement en vue de dessus un dispositif quantique, selon un premier mode de réalisation de la présente invention.
La figure 15 illustre schématiquement en vue de dessus un dispositif quantique, selon un deuxième mode de réalisation de la présente invention.
La figure 16 illustre schématiquement en vue de dessus un dispositif quantique, selon un troisième mode de réalisation de la présente invention.
La figure 17 illustre schématiquement en vue de dessus un dispositif quantique, selon un quatrième mode de réalisation de la présente invention.
La figure 18 illustre schématiquement en coupe transverse un dispositif quantique, selon un troisième mode de réalisation de la présente invention.
La figure 19 illustre schématiquement en coupe transverse un dispositif quantique, selon un quatrième mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs et/ou les dimensions des différentes couches, motifs et reliefs ne sont pas représentatives de la réalité. Pour des raisons de clarté, l'ensemble des références alphanumériques n'est pas systématiquement repris d'une figure à l'autre. Il est entendu que les éléments déjà décrits et référencés, lorsqu'ils sont reproduits sur une autre figure, portent typiquement les mêmes références alphanumériques, même si celles-ci ne sont pas explicitement mentionnées. L'homme du métier identifiera sans difficultés un même élément reproduit sur différentes figures.

### DESCRIPTION DÉTAILLÉE

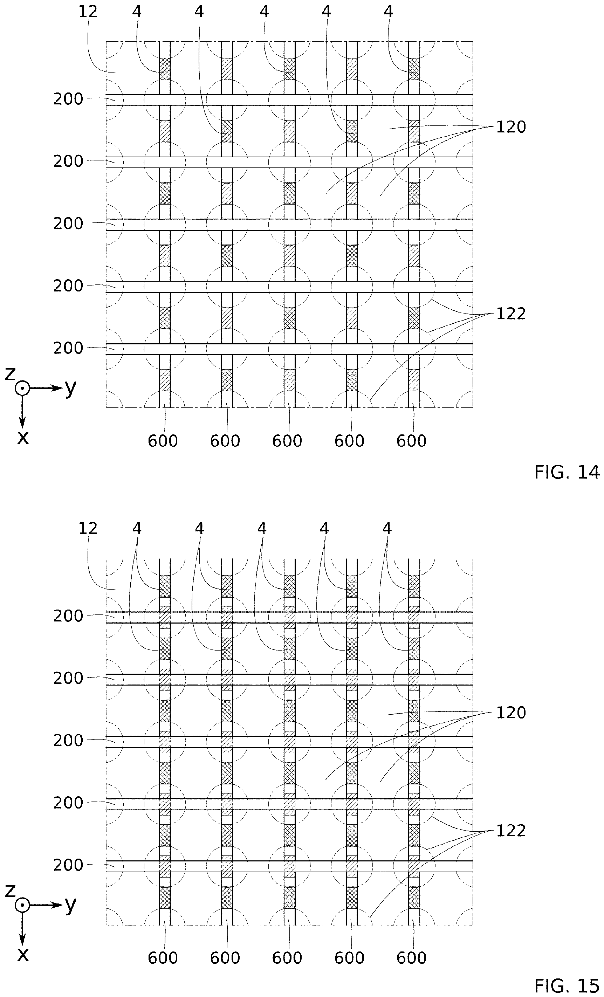

Avant d'entamer une revue détaillée de modes de réalisation de l'invention, sont énoncées ci-après des caractéristiques optionnelles qui peuvent éventuellement être utilisées en association ou alternativement :
Selon un exemple, chaque détecteur de charge est situé sous les grilles du deuxième ensemble de grilles. Typiquement, les grilles du deuxième ensemble de grilles sont arrangées en lignes parallèles entre elles, et les détecteurs de charge se situent au sein de ces lignes. Une grille du deuxième ensemble, sous forme de ligne, surmonte ainsi typiquement plusieurs détecteurs de charge. Les détecteurs de charge ne sont pas situés sous les grilles du premier ensemble de grilles. Typiquement, les grilles du premier ensemble de grilles sont arrangées en lignes parallèles entre elles, et les détecteurs de charge se situent entre ces lignes. Les grilles du premier ensemble de grilles et les grilles du deuxième ensemble de grilles sont typiquement perpendiculaires entre elles. La position des détecteurs de charge est par exemple illustrée aux figures 14 à 17, selon différents modes de réalisation.
Selon un exemple, le dispositif comprend une couche diélectrique sur la couche semi-conductrice, et la portion de chaque détecteur de charge située entre les grilles du premier ensemble de grilles est directement au contact de ladite couche diélectrique. Les détecteurs sont ainsi au plus près des boites quantiques.
Selon un exemple, l'au moins un réservoir de charges est un unique réservoir de charge commun à chaque détecteur de charge, pour une grille donnée du deuxième ensemble de grilles. Typiquement, lorsque les deuxièmes grilles sont arrangées en lignes parallèles les unes aux autres, le réservoir de charge est commun à chaque détecteur de charge pour une ligne donnée de deuxièmes grilles. Lorsqu'il y a plusieurs lignes de deuxièmes grilles, lesdites lignes étant indépendantes les unes des autres, il y a typiquement autant de réservoirs de charges que de lignes indépendantes.
Selon un exemple, chaque détecteur de charge comprend un ilot conducteur et au moins un réservoir de charge séparés l'un de l'autre par une barrière diélectrique. Ainsi, chaque détecteur peut être du type transistor à électron unique SET (acronyme de « Single Electron Transistor ») ou du type point quantique à simple réservoir SLQD (acronyme de « Single Load Quantum Dot »).
Selon un exemple, la portion de chaque détecteur de charge située entre les grilles du premier ensemble est un ilot conducteur. L'ilot conducteur est sensible à l'environnement électrostatique. Il est ainsi avantageusement situé à proximité des boites quantiques situées sous le niveau de grilles de contrôle considéré. La sensibilité de détection de charges dans les boites quantiques est ainsi améliorée.
Selon un exemple, chaque détecteur de charge comprend un seul réservoir de charge. Selon cet exemple, les détecteurs de charge sont de préférence du type point quantique à simple réservoir SLQD. Le réservoir se présente typiquement sous forme d'une grille ou d'une ligne de grille surmontant tous les détecteurs de cette même ligne.
Selon un exemple alternatif, chaque détecteur de charge comprend deux réservoirs de charge séparés, de type source et drain. Selon cet exemple, les détecteurs de charge sont de préférence du type transistor à électron unique SET.
Selon un exemple, la portion de chaque détecteur de charge est située entre les grilles de contrôle du premier ensemble de grilles de contrôle. La proximité du détecteur de charge avec les boites quantiques est optimisée. La sensibilité de détection est optimisée.
Selon un exemple, chaque grille de contrôle du premier ensemble comprend un premier étage et un deuxième étage séparés par une barrière diélectrique, le dispositif étant configuré de sorte que tous les deuxièmes étages sont polarisables indépendamment entre eux, de façon à contrôler un potentiel chimique de la portion de chaque détecteur de charge. La portion de chaque détecteur de charge située entre les grilles de contrôle du premier ensemble peut ainsi être polarisée selon une gamme de polarisation étendue. Un balayage sur les polarisations de cette gamme de polarisation peut avantageusement être effectué afin de déterminer un nombre de charges présentes dans la ou les boites quantiques situées sous ledit premier ensemble.
Selon un exemple, les premiers étages des grilles de contrôle du premier ensemble sont configurés pour contrôler les boites quantiques.
Selon un exemple, les grilles de contrôle du premier ensemble et les grilles du deuxième ensemble forment un quadrillage, en projection selon une première direction z, et les boites quantiques sont situées à l'aplomb des espaces vides du quadrillage.
Selon un exemple, les détecteurs de charge sont situés à l'aplomb de barrières tunnel séparant les boites quantiques entre elles.
Selon un exemple, la matrice bidimensionnelle de boites quantiques est organisée selon un premier réseau présentant un premier pas et les détecteurs de charge sont organisés selon un deuxième réseau présentant un deuxième pas égal à deux fois le premier pas.
Selon un exemple, la pluralité de boites quantiques comprend plus de seize boites quantiques arrangées en matrice bidimensionnelle, de préférence plus de trente-deux boites quantiques arrangées en matrice bidimensionnelle, de préférence plus de cent vingt-huit boites quantiques arrangées en matrice bidimensionnelle.
Selon un exemple, la pluralité de boites quantiques comprend N boites quantiques et la pluralité de détecteurs de charge comprend N/2 détecteurs de charge, de sorte que chaque détecteur de charge soit associé à deux boites quantiques de la matrice bidimensionnelle. De façon connue, notamment par la mesure préalable de diagrammes de stabilité, les signaux détectés par les détecteurs peuvent être reliés à l'une ou l'autre des boites quantiques. Cela permet la distinction entre les différentes boites quantiques associées à un détecteur. L'association de deux boites quantiques avec un détecteur trouve par exemple une application avantageuse dans le cadre de l'implémentation d'un code correcteur d'erreur quantique, par exemple de type « surface code ». Dans ce cas, il est nécessaire de lire uniquement l'information stockée sur une moitié des boites quantiques correspondant à des qubits « de mesure », lus périodiquement pour détecter des erreurs, l'autre moitié des boites quantiques correspondant à des qubits « de données » non mesurés pendant un calcul pour ne pas impacter l'information quantique qu'ils encodent.
Selon un exemple, pour quatre grilles de contrôle adjacentes du premier ensemble dénommées successivement première, deuxième, troisième et quatrième grilles de contrôle, le dispositif comprend un premier ilot conducteur d'un premier détecteur de charge entre les première et deuxième grilles de contrôle, ledit premier ilot conducteur étant surmonté par une première portion de barrière diélectrique reliant les première et deuxième grilles de contrôle, et un deuxième ilot conducteur d'un deuxième détecteur de charge entre les troisième et quatrième grilles de contrôle, ledit deuxième ilot conducteur étant surmonté par une deuxième portion de barrière diélectrique reliant les troisième et quatrième grilles de contrôle.
Selon un exemple, la matrice bidimensionnelle de boites quantiques et les détecteurs de charge sont respectivement organisés selon des réseaux présentant un même pas.
Selon un exemple, la pluralité de boites quantiques comprend N boites quantiques et la pluralité de détecteurs de charge comprend N détecteurs de charge, de sorte que chaque détecteur de charge soit associé à une boite quantique de la matrice bidimensionnelle. Chaque détecteur est ainsi typiquement associé à une seule boite quantique. Cela permet d'augmenter globalement le signal de détection de charges sur l'ensemble du réseau. La détection est ainsi moins bruitée et plus précise.
Selon un exemple, les premier et deuxième ensembles de grilles sont configurés pour confiner localement une particule ou une charge. Selon un exemple, le dispositif comprend un troisième ensemble de grilles configurées pour contrôler un potentiel chimique des boites quantiques. Cela permet de remplir ou vider les boites quantiques. Cela permet de manipuler l'information quantique.
Selon un exemple, la pluralité de détecteurs de charge est intégrée dans l'un parmi les premier, deuxième et troisième ensembles de grilles. Par exemple, l'intégration des détecteurs de charge dans le troisième ensemble de grille et directement à l'aplomb d'une boite quantique permet une meilleure sensibilité de mesure vis-à-vis de cette dernière.
Selon un exemple, les grilles du deuxième ensemble sont configurées pour piloter les détecteurs de charge par réflectométrie, de préférence par potentiel commun, en étant connectées à une induction et une capacité en série. Les détecteurs de charge sont ainsi parfaitement intégrés au sein des ensembles de grilles, notamment entre les grilles de contrôle des boites quantiques.
Selon un exemple, la formation de la pluralité de détecteurs de charge comprend la formation d'ilots conducteurs entre les grilles de contrôle du premier ensemble de grilles, et la formation d'une barrière diélectrique sur lesdits ilots conducteurs, avant la formation du deuxième ensemble de grilles. La barrière diélectrique sépare typiquement les ilots conducteurs d'un réservoir de charge.
Selon un exemple, les grilles de contrôle du premier ensemble sont orientées selon une deuxième direction x et les grilles du deuxième ensemble sont orientées selon une troisième direction y perpendiculaire à la deuxième direction x.
Selon un exemple, la formation de la barrière diélectrique comprend une structuration configurée pour former des portions de barrière diélectrique sous forme de bandes orientées en diagonale vis-à-vis des deuxième et troisième directions x, y, de sorte à ce que les détecteurs de charge formés soient moins nombreux que les boites quantiques formées, typiquement deux fois moins nombreux. Les intersections, en projection selon la première direction z, entre les bandes et les grilles de contrôle du premier niveau définissent les détecteurs de charge. Selon la largeur et l'orientation des bandes, il est ainsi possible de former un sous-réseau de détecteurs parmi le réseau bidimensionnel de boites quantiques.
Selon un exemple, le procédé comprend une connexion des grilles du deuxième ensemble à une induction et une capacité en série, et un pilotage des détecteurs de charge par réflectométrie.

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention. Les caractéristiques et les avantages d'un aspect de l'invention, par exemple le dispositif ou le procédé, peuvent être adaptés *mutatis mutandis* à l'autre aspect de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

On entend par un substrat, un film, une couche, « à base » d'un matériau A, un substrat, un film, une couche comprenant ce matériau A uniquement ou ce matériau A et éventuellement d'autres matériaux, par exemple des éléments dopants ou des éléments d'alliage.

Dans la suite, les premier, deuxième et/ou troisième ensembles de grilles sont également appelés respectivement des premier, deuxième et/ou troisième niveaux de grilles. Un « niveau » de grilles, comme un niveau d'interconnexions ou de métallisation, correspond typiquement à une couche ou un ensemble de couches, structurés, d'un circuit microélectronique, selon le sens habituellement donné dans le domaine de la microélectronique.

En fonctionnement, le dispositif comprend des boîtes quantiques régulièrement distribuées dans la couche semi-conductrice, sous forme de matrice bidimensionnelle. Ces boîtes quantiques ne sont pas nécessairement physiquement définies lorsque le dispositif ne fonctionne pas. Les boîtes quantiques peuvent correspondre à des zones de confinement créées dans la couche semi-conductrice lorsqu'une ou plusieurs tensions sont appliquées aux différentes grilles du dispositif. La couche semi-conductrice est donc adaptée à la formation de boites quantiques.

Les grilles disposées au-dessus des boîtes quantiques, typiquement les premières grilles, contrôlent le couplage entre les boîtes quantiques. Les grilles disposées entre des boîtes quantiques, typiquement les deuxièmes grilles, contrôlent les barrières entre ces boîtes quantiques.

Les boîtes quantiques peuvent être confinées latéralement dans la couche semi-conductrice par des éléments structurels, typiquement des trous formés dans la couche semi-conductrice. Le confinement latéral des boîtes quantiques peut également être réalisé de manière électrique, à l'aide de deux premières grilles et de deux deuxièmes grilles.

Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. Elle est notée S_{A:B}. Une sélectivité S_{A:B} de 10:1 signifie que la vitesse de gravure du matériau A est 10 fois supérieure à la vitesse de gravure du matériau B.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, on parlera préférentiellement d'épaisseur pour une couche ou un film, et de hauteur pour un dispositif ou une structure. L'épaisseur est prise selon une direction normale au plan d'extension principal de la couche ou du film. Ainsi, une couche superficielle de silicium présente typiquement une épaisseur selon z. Un motif de grille formé sur une telle couche superficielle présente une hauteur selon z. Les termes relatifs « sur », « surmonte », « sous », « sous-jacent » se réfèrent à des positions prises selon la direction z. Une dimension « latérale » correspond à une dimension selon une direction du plan xy. On entend par une extension « latérale » ou « latéralement », une extension selon une ou des directions du plan xy.

Un élément situé « à l'aplomb » ou « au droit d' » un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures en coupe transverse.

Les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

Les figures nA (n=1...11) illustrent schématiquement en coupe transverse des étapes de fabrication d'un dispositif quantique comprenant des détecteurs de charge, selon un premier mode de réalisation. Les figures nB (n=1...11) illustrent schématiquement en perspective les étapes de fabrication illustrées aux figures nA correspondantes.

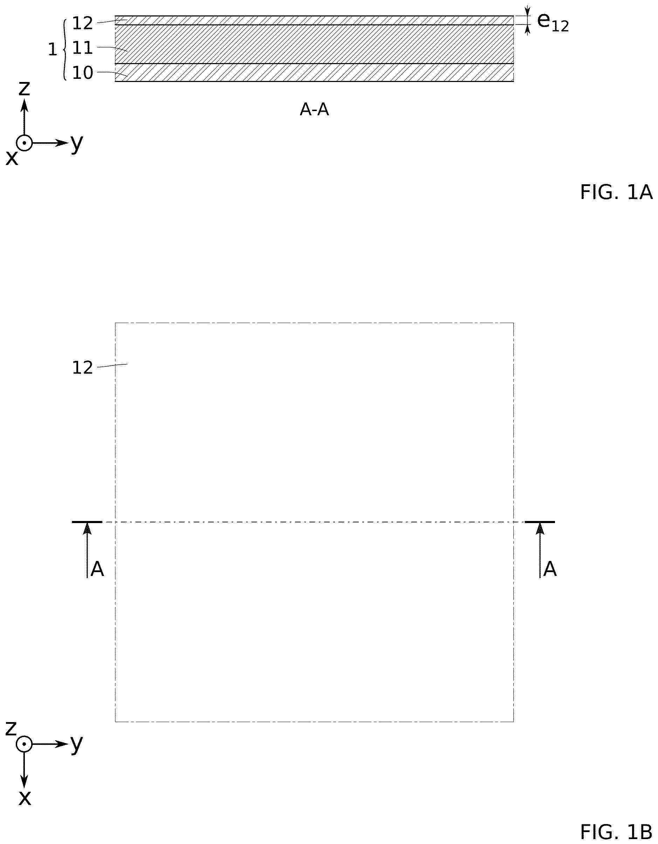

Comme illustré aux figures 1A, 1B, les premières étapes consistent à fournir un substrat 1 de type silicium sur isolant SOI, comprenant une couche de support 10, typiquement un substrat massif de silicium dit « bulk », une couche d'oxyde enterrée 11 appelée « BOX », et une couche superficielle de silicium 12 dite topSi. La couche topSi 12 présente typiquement une épaisseur e₁₂ de l'ordre de 5 nm à 20 nm. Cette couche topSi 12 est destinée à contenir les boites quantiques. Ces boites quantiques peuvent être formées ultérieurement, par simple confinement électrostatique au sein de la couche topSi 12. Alternativement, elles peuvent être créées physiquement, par exemple en formant des trous régulièrement distribués dans le topSi 12 (non illustré).

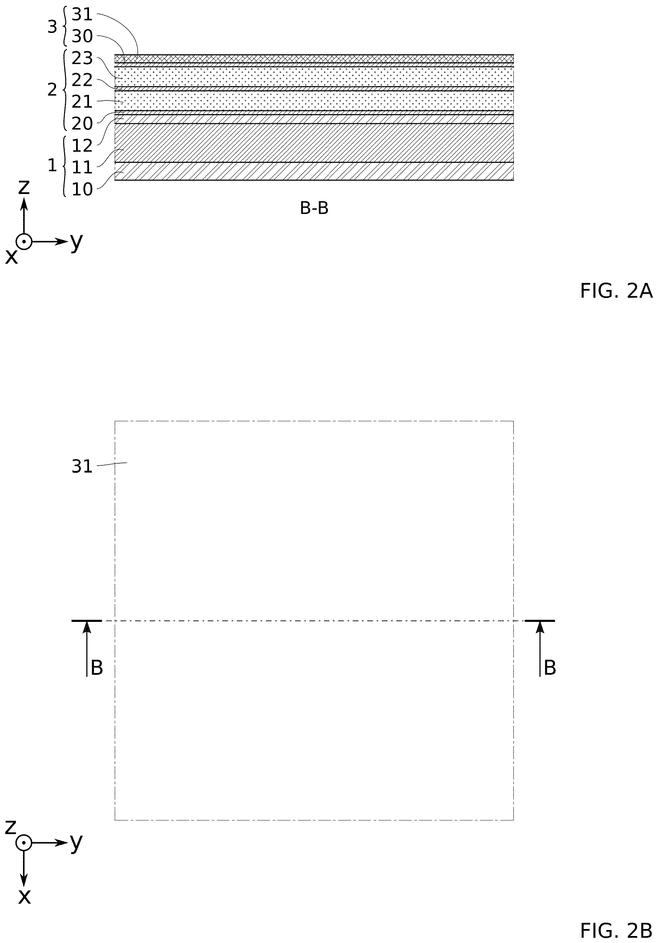

Comme illustré aux figures 2A, 2B, un empilement 2 de grille est formé sur le substrat 1. Cet empilement 2 est destiné à former, après structuration, le premier niveau de grille du dispositif. Cet empilement 2 comprend typiquement, selon z en partant du substrat 1, une couche diélectrique 20, une première couche conductrice 21, par exemple à base de métal ou de silicium polycristallin dopé, une couche diélectrique 22, une deuxième couche conductrice 23, par exemple à base de métal ou de silicium polycristallin dopé. L'empilement 2 est surmonté par une couche de masquage 3 comprenant typiquement une couche d'oxyde de silicium 30 et/ou une couche de nitrure de silicium 31. Cette couche de masquage 3 est destinée à former, après structuration, un masque dur pour la gravure de l'empilement 2.

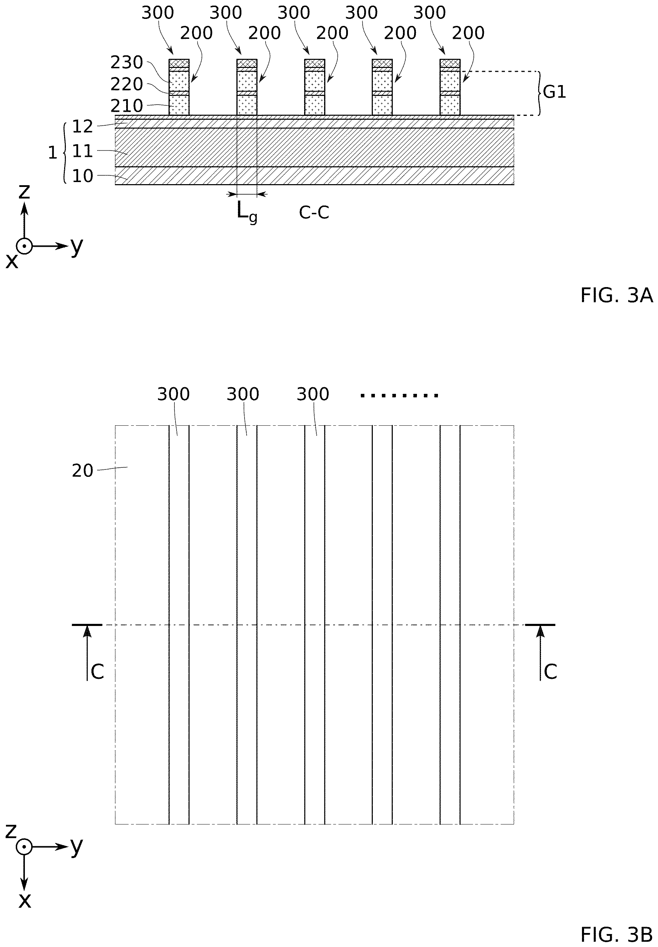

Comme illustré aux figures 3A, 3B, la couche de masquage 3 est d'abord structurée par lithographie et gravure pour former un masque dur 300 définissant des premiers motifs de grille sur l'empilement 2, alignés selon x dans cet exemple. L'empilement 2 est ensuite gravé, typiquement par une gravure sèche anisotrope selon z, pour former des grilles 200. Une gravure ionique réactive (RIE) ou une gravure plasma à base d'espèces fluorocarbonées peut être utilisée pour graver successivement les couches 23, 22 et 21 de l'empilement 2. La gravure de l'empilement 2 est configurée pour s'arrêter sur la couche diélectrique 20. Chaque grille 200 comprend ainsi un premier étage 210, une barrière diélectrique 220, un deuxième étage 230. Les grilles 200 forment le premier niveau de grille G1 du dispositif. Les grilles 200 sont surmontées à ce stade par le masque dur 300. Les grilles 200 présentent une dimension en largeur selon y L_{g}. Le premier étage 210 des grilles 200 est typiquement configuré pour contrôler des qubits dans les boites quantiques. Le deuxième étage 230 des grilles 200 est typiquement configuré pour contrôler les détecteurs de charge associés aux boites quantiques.

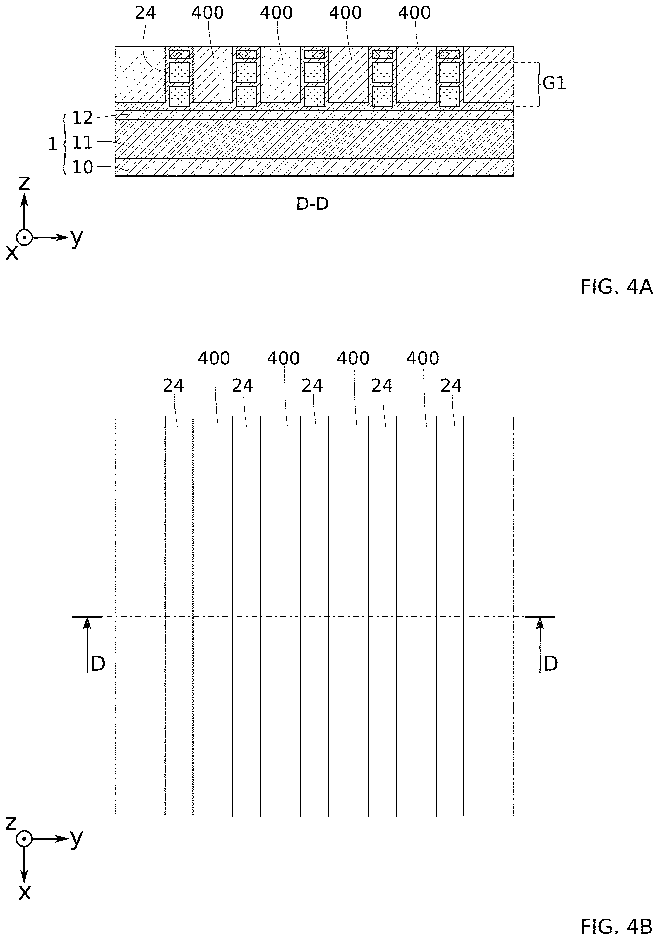

Comme illustré aux figures 4A, 4B, une couche diélectrique 24, également appelée liner, est déposée de façon conforme sur les parties exposées de la couche diélectrique 20, sur les flancs des grilles 200 et sur le masque dur 300. Les espaces situés entre les grilles 200 sont ensuite remplis par dépôt d'une couche conductrice, par exemple à base de silicium polycristallin dit polySi. Une planarisation, typiquement par polissage mécano-chimique CMP, est ensuite effectuée avec arrêt sur la couche diélectrique 24 au sommet des grilles surmontées par le masque dur. Des ilots conducteurs 400 sont ainsi formés entre les grilles du premier niveau de grilles du dispositif. Ces ilots conducteurs 400 sont typiquement « auto-alignés ». Ils sont directement formés entre les grilles du premier niveau, et donc alignés vis-à-vis desdites grilles, sans que cela nécessite d'étape de lithographie.

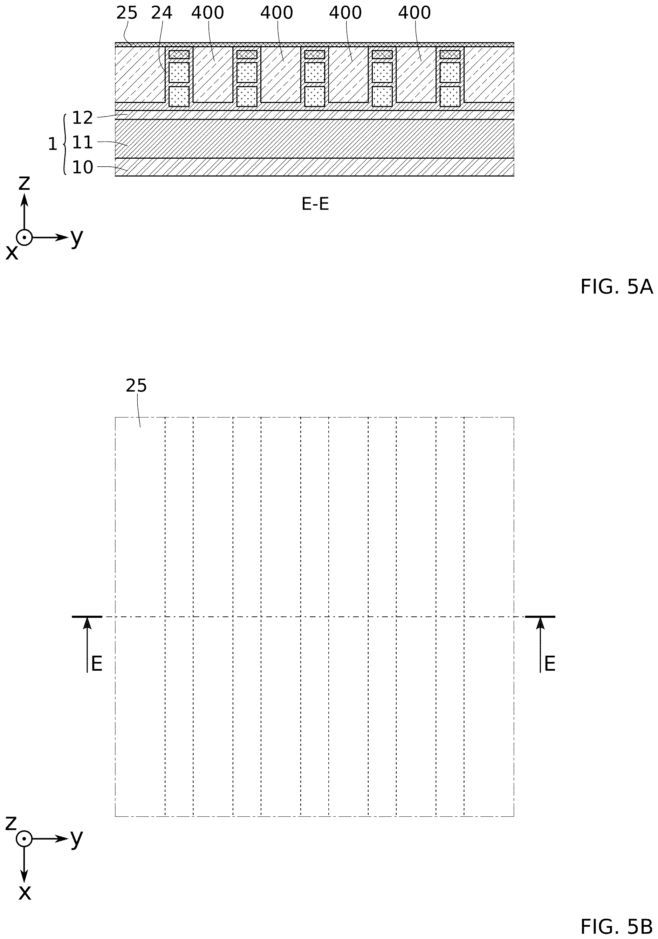

Comme illustré aux figures 5A, 5B, une couche diélectrique 25 est déposée de façon continue sur l'ensemble des ilots conducteurs 400 et sur les parties exposées de la couche diélectrique 24. La couche diélectrique 25 est destinée à séparer un réservoir de charges électriques, typiquement situé au-dessus de cette couche 25, des ilots conducteurs 400 situés sous cette couche 25. La couche diélectrique 25 est configurée pour rester perméable au passage de charges électriques entre le réservoir de charges et les ilots conducteurs 400.

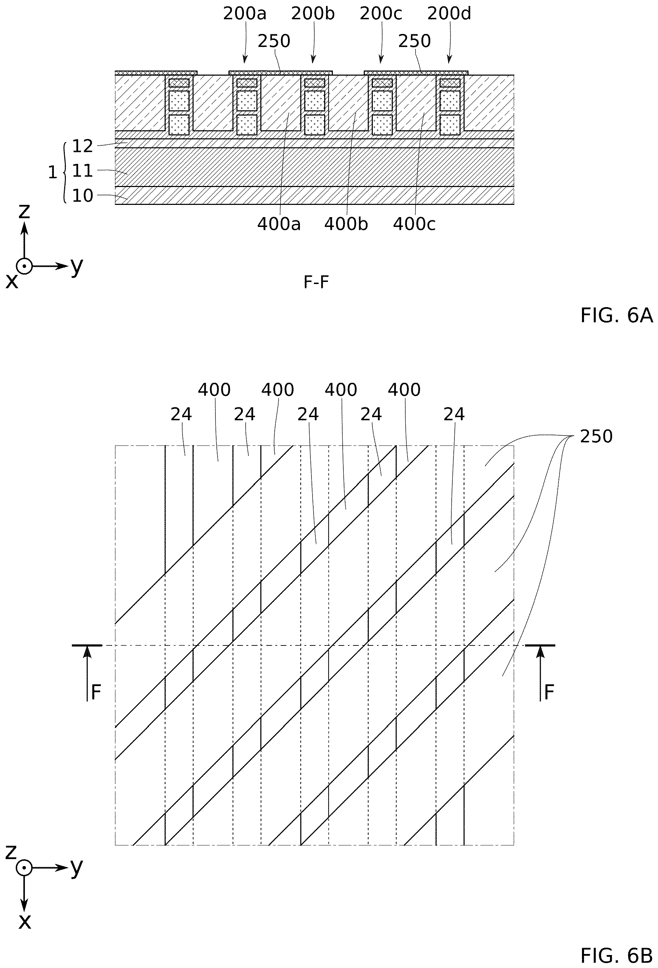

Comme illustré aux figures 6A, 6B, cette couche diélectrique 25 est ensuite structurée par gravure, typiquement sous forme de bandes orientées en diagonale vis-à-vis des grilles sous-jacentes, par exemple à 45° vis-à-vis des axes, x, y (figure 6B). Cela permet de couvrir périodiquement un ilot conducteur 400 sur deux selon les directions x et y. Ainsi, comme illustré à la figure 6A en coupe transverse selon la ligne de coupe A-A représentée sur la figure 6B, pour quatre grilles successives 200a, 200b, 200c, 200d, seuls les ilots conducteurs 400a et 400c situés respectivement entre les grilles 200a, 200b et 200c, 200d, sont couverts par une portion 250 de barrière diélectrique. L'ilot conducteur 400b situé entre les grilles 200b, 200c n'est pas couvert le long de la ligne de coupe A-A.

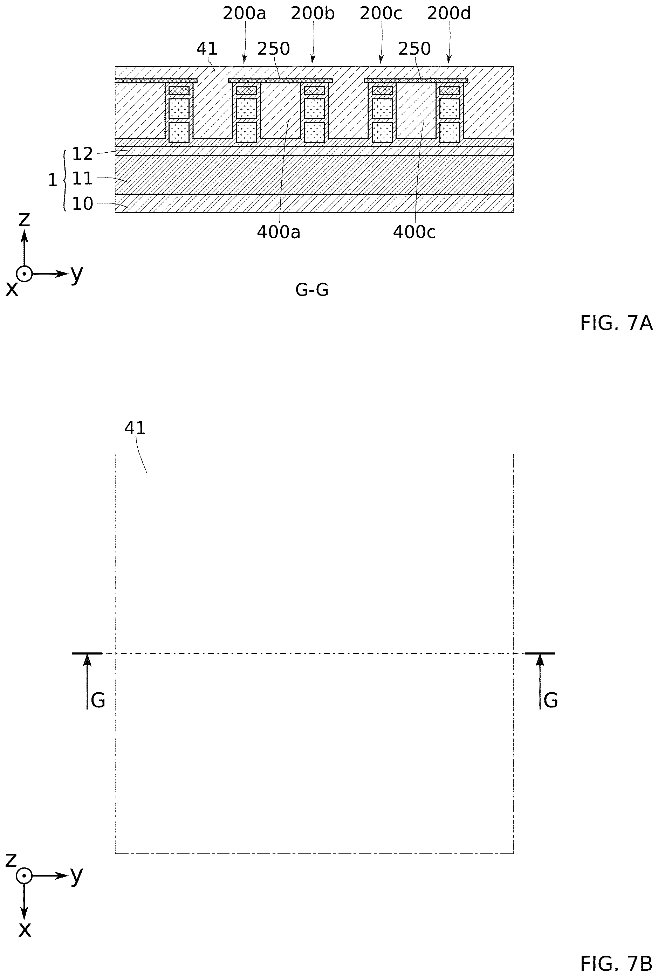

Comme illustré aux figures 7A, 7B, une couche conductrice 41, typiquement à base de polySi, est ensuite déposée, puis planarisée par CMP. Cette couche conductrice 41 est destinée à former un réservoir de charge pour les ilots conducteurs 400a, 400c des détecteurs de charge. La couche conductrice 41 est séparée des ilots conducteurs 400a, 400c par les portions 250 de barrière diélectrique.

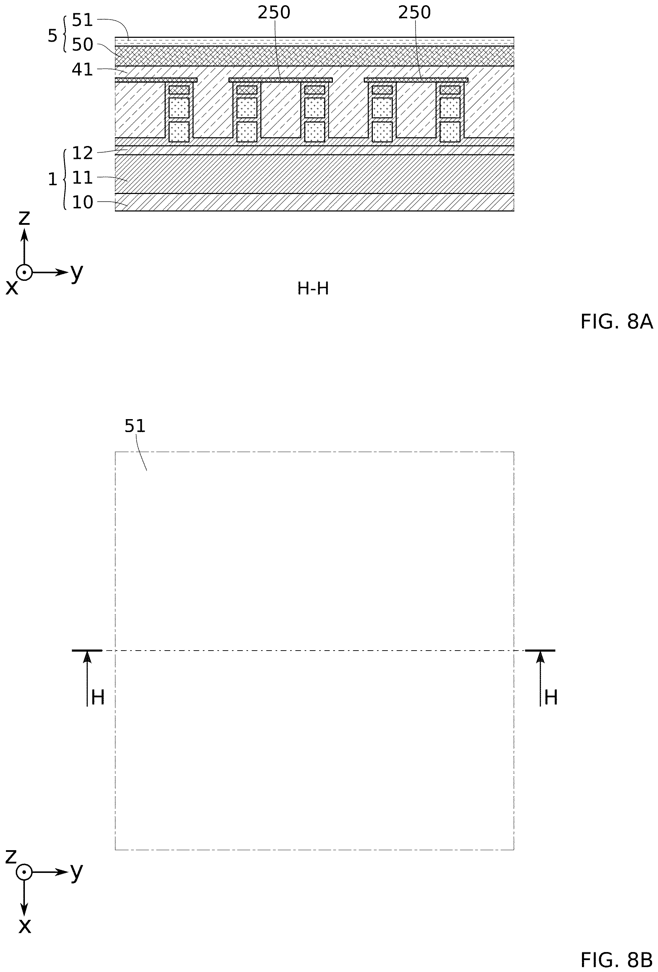

Comme illustré aux figures 8A, 8B, une couche de masquage 5 comprenant typiquement une couche de nitrure de silicium 50 et/ou une couche d'oxyde de silicium 51 est déposée sur la couche conductrice 41.

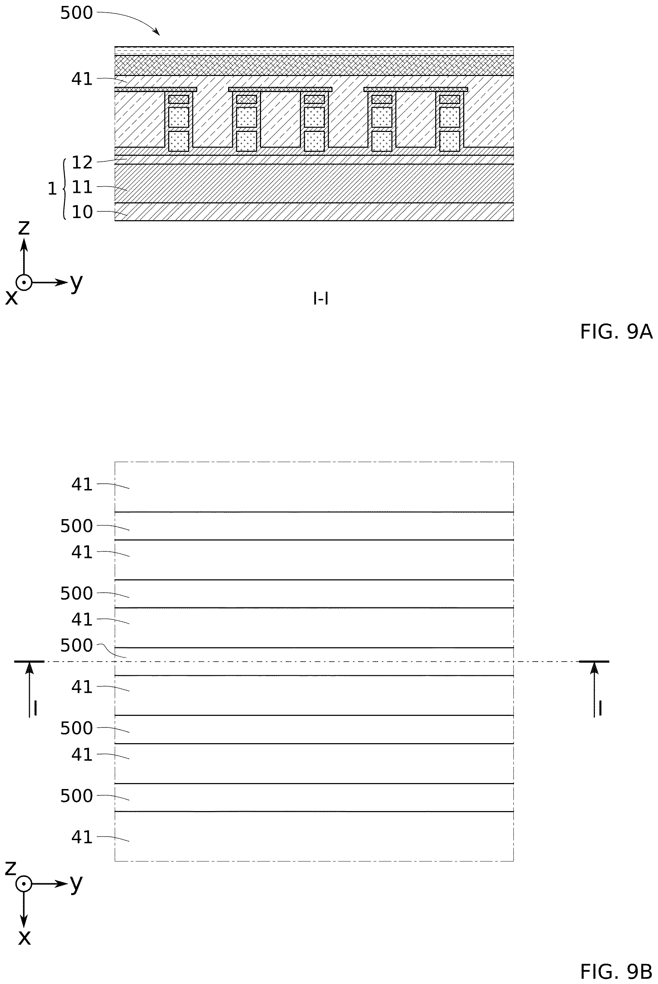

Comme illustré aux figures 9A, 9B, la couche de masquage 5 est ensuite structurée par lithographie et gravure pour former un masque dur 500 définissant des deuxièmes motifs de grille, alignés selon y dans cet exemple.

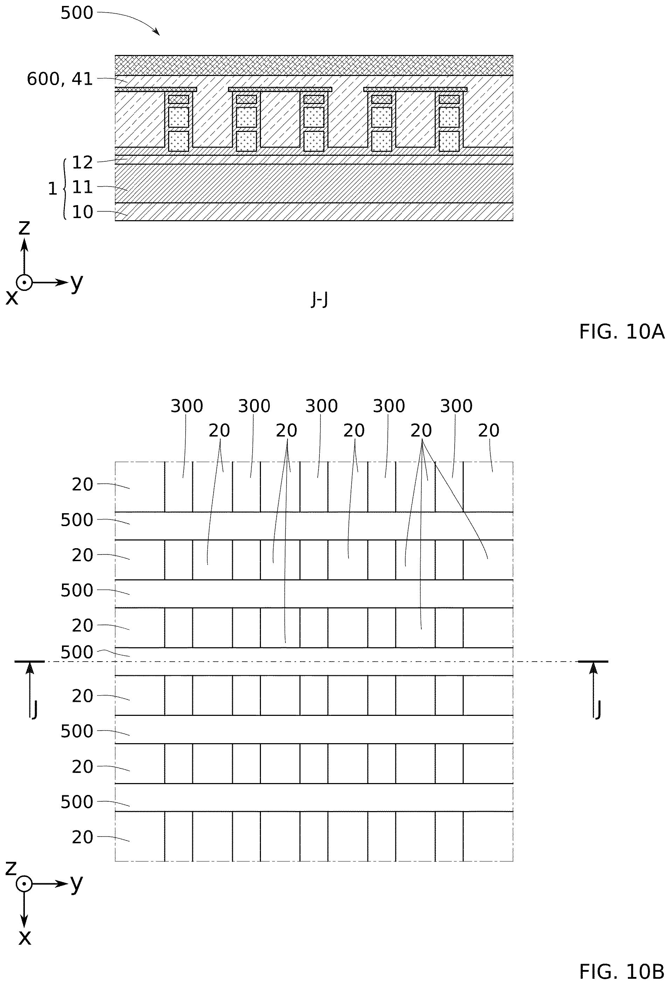

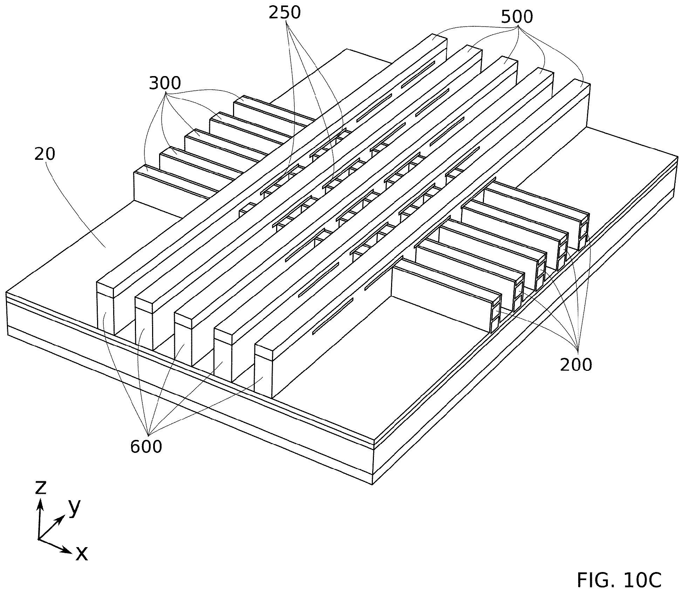

Comme illustré aux figures 10A, 10B, 10C, une gravure sèche anisotrope selon z est ensuite effectuée, pour former des grilles 600. Cette gravure permet typiquement de retirer les parties de la couche 41 et des ilots conducteurs 400 non couvertes par un masque dur. La gravure est typiquement configurée pour s'arrêter dans le masque dur 300, au niveau de la couche SiN du masque dur 300, dans le masque dur 500, au niveau de la couche SiN du masque dur 500, et sur la couche diélectrique 20 entre les masques durs 300, 500.

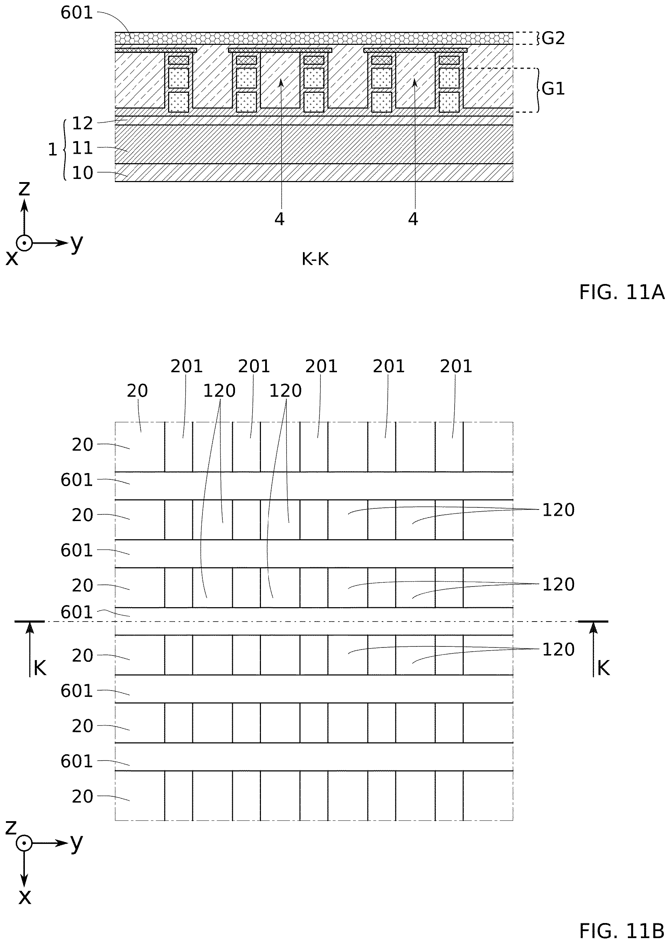

Comme illustré aux figures 11A, 11B, Les parties exposées des masques durs 300, 500, principalement à base de SiN, sont retirées sélectivement à la couche diélectrique 20 au fond des tranchées et cavités bordant les grilles 200, 600. Le sommet des grilles 200, 600 à base de poly Si est ainsi exposé. Une siliciuration des grilles 200, 600 est ensuite effectuée, de façon classique, pour obtenir des parties 201, 601 sommitales de grilles siliciurées. Vu de dessus (figure 11B), le maillage des grilles 200, 600 permet de définir une matrice bidimensionnelle de boites quantiques ou de points quantiques. Les boites quantiques 120 sont situées dans les espaces intergrilles, entre les grilles 200, 600, en projection selon z (figure 11B). Les boites quantiques 120 sont confinées dans le topSi. Les détecteurs de charge 4 sont intégrés dans les niveaux G1, G2 de grilles du dispositif.

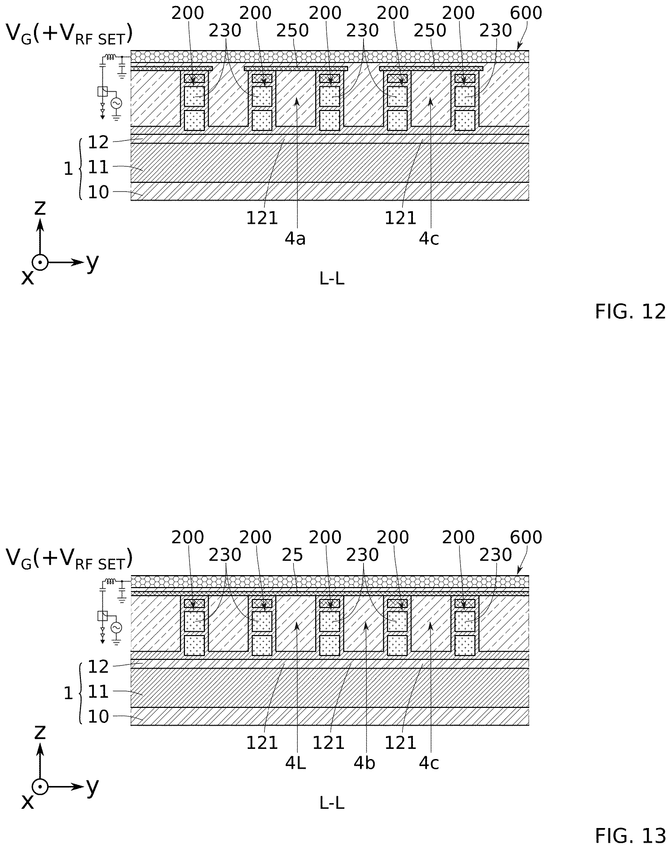

Le dispositif illustré à la figure 12 est ainsi obtenu. Ce dispositif comprend des boites quantiques 120 dans la couche de topSi 12, localisées entre les différentes intersections de grilles 200, 600. Le dispositif comprend en outre des détecteurs de charge 4a, 4c de type SLQD en partie formés entre les grilles 200 sous les portions 250 de barrière diélectrique. Les détecteurs de charge sont situés au-dessus des barrières tunnel 121 reliant deux boites quantiques entre elles. Dans cet exemple, le dispositif comprend deux fois moins de détecteurs de charge que de boites quantiques 120. Un fonctionnement des détecteurs de charge 4a, 4c par réflectométrie peut avantageusement être envisagé, en connectant les grilles 600 à un système de réflectométrie comprenant une capacité et une induction en série. Cette configuration correspond à une détection par réflectométrie par potentiel commun, dans la mesure où tous les détecteurs 4a, 4c sont sondés par une même grille 600.

Une polarisation des détecteurs de charge 4a, 4c par le biais des deuxièmes étages 230 de grilles 200 peut avantageusement être effectuée, pour sonder la présence de charges dans les boites quantiques 120. Le détecteur de charge 4a et le détecteur de charge 4c peuvent être polarisés indépendamment l'un de l'autre.

D'autres modes de réalisation du dispositif peuvent être envisagés.

La figure 13 illustre un mode de réalisation du dispositif dans lequel un détecteur de charge 4a, 4b, 4c est prévu pour chaque boite quantique 120. Dans ce mode de réalisation la couche diélectrique 25 forme une barrière continue au-dessus des ilots conducteurs des détecteurs de charge 4a, 4b, 4c. Il suffit de ne pas structurer cette couche diélectrique 25, telle qu'illustrée aux figures 5A, 5B, pour obtenir le dispositif illustré à la figure 13. Les détecteurs peuvent fonctionner par réflectométrie par potentiel commun, comme précédemment. Une polarisation des détecteurs de charge 4a, 4b, 4c par le biais des deuxièmes étages 230 de grilles 200 peut avantageusement être effectuée, pour sonder la présence de charges dans les boites quantiques 120. Les détecteurs de charge 4a, 4b, 4c peuvent être polarisés indépendamment.

La figure 14 illustre en vue de dessus un arrangement en réseau 2D de boites quantiques 120 situées entre les intersections des grilles 200 et 600, associé à un sous-réseau de détecteurs 4 deux fois moins nombreux que les boites quantiques 120, de façon similaire à l'architecture présentée à la figure 12. Dans cet exemple des trous 122 sont formés dans la couche topSi 12 pour ajouter un confinement structurel aidant à la définition des boites quantiques 120. Les boites quantiques 120 sont situées entre les trous 122. Les détecteurs 4 sont situés à l'aplomb de certaines barrières tunnel séparant les boites quantiques 120.

La figure 15 illustre en vue de dessus un arrangement en réseau 2D de boites quantiques 120 situées entre les intersections des grilles 200 et 600, associé à un sous-réseau de détecteurs 4 aussi nombreux que les boites quantiques 120, de façon similaire à l'architecture présentée à la figure 13. Dans cet exemple des trous 122 sont formés dans la couche topSi 12 pour ajouter un confinement structurel aidant à la définition des boites quantiques 120. Les boites quantiques 120 sont situées entre les trous 122. Les détecteurs 4 sont situés à l'aplomb des barrières tunnel séparant les boites quantiques 120.

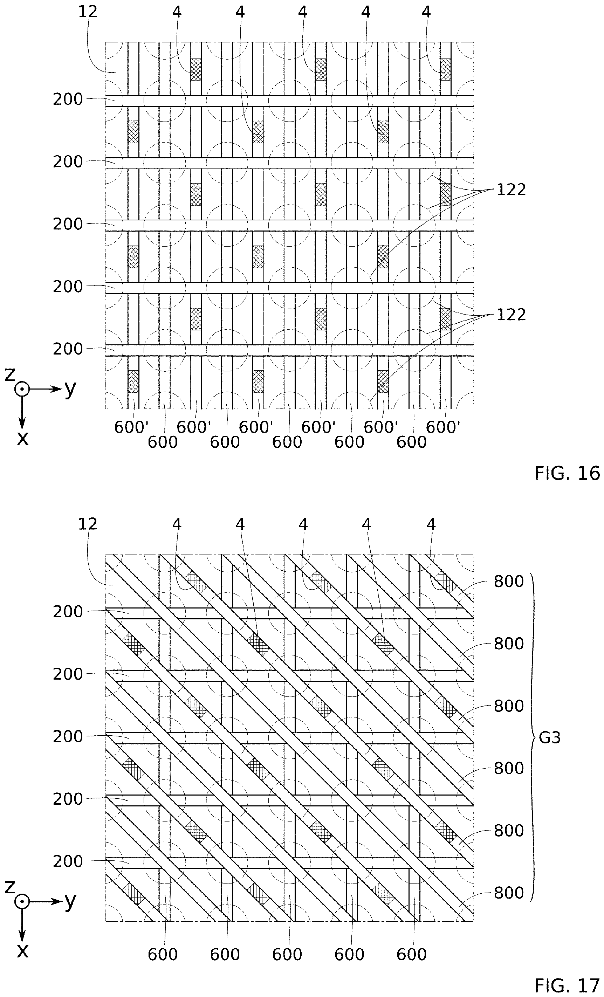

La figure 16 illustre en vue de dessus un arrangement en réseau 2D de boites quantiques 120 situées entre les intersections des grilles 200 et 600. Dans cet exemple, les grilles 600, 600' du deuxième niveau ont été doublées - le pas du réseau selon y a été divisé par deux - de façon à obtenir à la fois un contrôle des barrières tunnel par les grilles 600 et un contrôle des potentiels chimiques des boites quantiques par les grilles 600'. Dans cet exemple, le sous-réseau de détecteurs 4 comprend deux fois moins de détecteurs que les boites quantiques 120. Les boites quantiques 120 sont situées entre les trous 122. Les détecteurs 4 sont situés à l'aplomb de certaines boites quantiques 120. Les grilles 600, 600' du deuxième niveau peuvent être réalisées simultanément. Alternativement, les grilles 600' peuvent être formées après les grilles 600, par exemple sur un troisième niveau de grilles du dispositif. L'homme du métier saura adapter la formation des différents niveaux de grilles en fonction des besoins.

La figure 17 illustre en vue de dessus un arrangement en réseau 2D de boites quantiques 120 situées entre les intersections des grilles 200 et 600. Dans cet exemple, un troisième niveau G3 de grilles 800 a été ajouté au-dessus des premier et deuxième niveaux de grilles 200, 600 pour contrôler les potentiels chimiques des boites quantiques 120. Les détecteurs de charge 4 peuvent être intégrés sous les grilles 800 de ce troisième niveau. Selon une possibilité non illustrée, les détecteurs de charge 4 peuvent être intégrés entre les grilles 800 de ce troisième niveau, par exemple à l'aplomb de certaines barrières tunnel.

L'architecture de dispositif de la présente invention permet ainsi d'envisager une multitude de configurations pour le placement des détecteurs 4 entre les grilles d'au moins un niveau de grilles. Une telle architecture est avantageusement compacte et versatile.

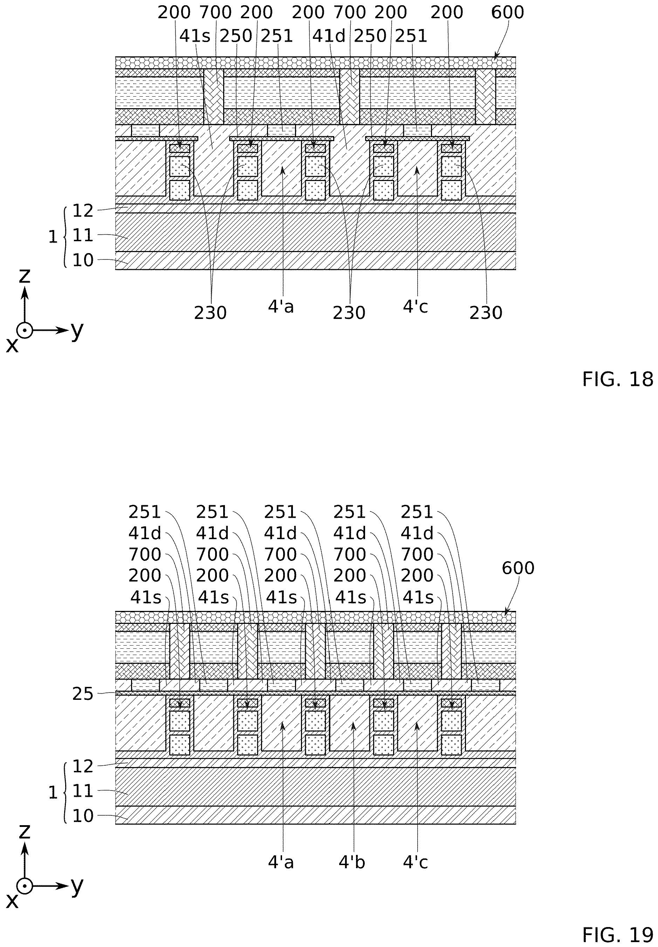

Les figures 18 et 19 illustrent deux autres modes de réalisation du dispositif dans lequel les détecteurs de charge sont de type SET, avec deux réservoirs de charge 41s, 41d « source et drain » associés à un ilot conducteur via la barrière diélectrique 250, 25. Les deux réservoirs de charge 41s, 41d sont typiquement séparés par un bloc diélectrique 251 surmontant la barrière diélectrique 250, 25, environ à égale distance des grilles 200.

La figure 18 illustre un premier mode de réalisation dans lequel le dispositif comprend deux fois moins de détecteurs de charge 4'a, 4'c de type SET que de boites quantiques 120. Les deux réservoirs de charge 41s, 41d sont typiquement reliés à la grille 600 par des vias 700. Comme précédemment, un fonctionnement des détecteurs de charge 4'a, 4'c par réflectométrie peut avantageusement être envisagé, en connectant les grilles 600 à un système de réflectométrie.

La figure 19 illustre un deuxième mode de réalisation dans lequel le dispositif comprend autant de détecteurs de charge 4'a, 4'b, 4'c de type SET que de boites quantiques 120. Les deux réservoirs de charge 41s, 41d sont typiquement reliés à la grille 600 par des vias 700. Comme précédemment, un fonctionnement des détecteurs de charge 4'a, 4'b, 4'c par réflectométrie peut avantageusement être envisagé, en connectant les grilles 600 à un système de réflectométrie.

Au vu de la description qui précède, il apparaît clairement que le dispositif proposé offre une solution particulièrement efficace et versatile pour intégrer des détecteurs de charge dans les niveaux de grilles associés à une matrice 2D de boites quantiques, en améliorant la compacité et la sensibilité de ce dispositif quantique.

L'invention n'est pas limitée aux modes de réalisations précédemment décrits.

## Revendications

1. Dispositif quantique comprenant :
• une couche semi-conductrice (12) adaptée pour former une pluralité de boites quantiques (120) arrangée en une matrice bidimensionnelle de boites quantiques ;
• une pluralité de détecteurs (4, 4a, 4'a, 4b, 4'b) de charge couplés capacitivement aux boites quantiques (120) de la pluralité de boites quantiques,
• un premier ensemble (G1) de grilles (200) comprenant des grilles de contrôle des boites quantiques (120), surmontant la couche semi-conductrice (12),
• un deuxième ensemble (G2) de grilles (600) comprenant des grilles destinées à former au moins un réservoir de charges pour les détecteurs (4, 4a, 4'a, 4b, 4'b) de charge,
le dispositif étant **caractérisé en ce que** chaque détecteur de charge (4, 4a, 4'a, 4b, 4'b) comprend une portion (400, 400a, 400b) située entre les grilles (200) du premier ensemble (G1) de grilles, et **en ce que** chaque grille (200) de contrôle du premier ensemble (G1) comprend un premier étage (210) et un deuxième étage (230) séparés par une barrière diélectrique (220), le dispositif étant configuré de sorte que tous les deuxièmes étages (230) sont polarisables indépendamment entre eux, de façon à contrôler un potentiel chimique de la portion (400, 400a, 400b) de chaque détecteur de charge.

2. Dispositif selon la revendication précédente dans lequel les premiers étages (210) des grilles de contrôle du premier ensemble sont configurés pour contrôler les boites quantiques (120).

3. Dispositif selon l'une quelconque des revendications précédentes dans lequel l'au moins un réservoir de charges est un unique réservoir de charge commun à chaque détecteur (4, 4a, 4'a, 4b, 4'b) de charge, pour une grille (600) donnée du deuxième ensemble (G2) de grilles (600), les détecteurs de charge étant par exemple du type point quantique à simple réservoir SLQD.

4. Dispositif selon l'une quelconque des revendications précédentes comprenant une couche diélectrique (20) sur la couche semi-conductrice (12), dans lequel la portion (400, 400a, 400b) de chaque détecteur de charge (4, 4a, 4'a, 4b, 4'b) située entre les grilles (200) du premier ensemble (G1) de grilles est directement au contact de ladite couche diélectrique (20).

5. Dispositif selon l'une quelconque des revendications précédentes dans lequel la portion de chaque détecteur de charge située entre les grilles du premier ensemble (G1) est un ilot conducteur (400, 400a, 400b).

6. Dispositif selon l'une quelconque des revendications précédentes dans lequel les détecteurs (4) de charge sont situés à l'aplomb des boites quantiques (120), selon une première direction z.

7. Dispositif selon l'une quelconque des revendications précédentes dans lequel la matrice bidimensionnelle de boites quantiques (120) est organisée selon un premier réseau présentant un premier pas et les détecteurs (4, 4a, 4'a, 4b, 4'b) de charge sont organisés selon un deuxième réseau présentant un deuxième pas égal à deux fois le premier pas, et dans lequel la pluralité de boites quantiques (120) comprend N boites quantiques et la pluralité de détecteurs (4, 4a, 4'a) de charge comprend N/2 détecteurs de charge, de sorte que chaque détecteur de charge soit associé à deux boites quantiques (120) de la matrice bidimensionnelle.

8. Dispositif selon la revendication précédente en combinaison avec la revendication 4 dans lequel, pour quatre grilles (200a, 200b, 200c, 200d) de contrôle adjacentes du premier ensemble (G1), dénommées successivement première, deuxième, troisième et quatrième grilles de contrôle, le dispositif comprend un premier ilot conducteur (400a) d'un premier détecteur (4a) de charge entre les première et deuxième grilles de contrôle (200a, 200b), ledit premier ilot conducteur (400a) étant surmonté par une première portion (250) de barrière diélectrique reliant les première et deuxième grilles de contrôle (200a, 200b), et un deuxième ilot conducteur (400c) d'un deuxième détecteur (4c) de charge entre les troisième et quatrième grilles de contrôle (200c, 200d), ledit deuxième ilot conducteur (400c) étant surmonté par une deuxième portion (250) de barrière diélectrique reliant les troisième et quatrième grilles de contrôle (200c, 200d).

9. Dispositif selon l'une quelconque des revendications 1 à 6 dans lequel la matrice bidimensionnelle de boites quantiques (120) et les détecteurs (4, 4a, 4'a, 4b, 4'b) de charge sont respectivement organisés selon des réseaux présentant un même pas, et dans lequel la pluralité de boites quantiques (120) comprend N boites quantiques et la pluralité de détecteurs (4, 4a, 4'a, 4b, 4'b) de charge comprend N détecteurs de charge, de sorte que chaque détecteur de charge soit associé à une boite quantique (120) de la matrice bidimensionnelle.

10. Dispositif selon l'une quelconque des revendications précédentes dans lequel les grilles (600) du deuxième ensemble (G2) sont configurées pour piloter les détecteurs (4, 4a, 4'a, 4b, 4'b) de charge par réflectométrie, de préférence par potentiel commun, en étant connectées à une induction et une capacité en série.

11. Procédé de réalisation d'un dispositif quantique selon l'une quelconque des revendications précédentes, comprenant :
• une formation d'une couche semi-conductrice (12) destinée à comprendre une pluralité de boites quantiques (120) arrangées en matrice bidimensionnelle,
• une formation d'un premier ensemble (G1) de grilles (200) comprenant des grilles de contrôle des boites quantiques, surmontant la couche semi-conductrice (12),
• une formation d'un deuxième ensemble (G2) de grilles (600) comprenant des grilles destinées à former au moins un réservoir de charges pour des détecteurs (4, 4a, 4'a, 4b, 4'b) de charge,
• une formation d'une pluralité de détecteurs (4, 4a, 4'a, 4b, 4'b) de charge couplés capacitivement aux boites quantiques (120) de la pluralité de boites quantiques, ladite formation étant configurée de sorte que chaque détecteur de charge comprenne une portion (400, 400a, 400c) située entre les grilles du premier ensemble (G1) de grilles.

12. Procédé selon la revendication précédente dans lequel la formation de la pluralité de détecteurs (4, 4a, 4'a, 4b, 4'b) de charge comprend la formation d'ilots conducteurs (400, 400a, 400b, 400c) entre les grilles (200) de contrôle du premier ensemble (G1) de grilles, et la formation d'une barrière diélectrique (250, 25) sur lesdits ilots conducteurs, avant la formation du deuxième ensemble (G2) de grilles.

13. Procédé selon la revendication précédente dans lequel les grilles (200) de contrôle du premier ensemble (G1) sont orientées selon une deuxième direction x et les grilles (600) du deuxième ensemble (G2) sont orientées selon une troisième direction y perpendiculaire à la deuxième direction x, et dans lequel la formation de la barrière diélectrique comprend une structuration configurée pour former des portions (250) de barrière diélectrique sous forme de bandes orientées en diagonale vis-à-vis des deuxième et troisième directions x, y, de sorte à ce que les détecteurs (4, 4a, 4c) de charge formés soient moins nombreux que les boites quantiques (120) formées, typiquement deux fois moins nombreux.

14. Procédé selon l'une quelconque des revendications 11 à 13 comprenant une connexion des grilles (600) du deuxième ensemble (G2) à une induction et une capacité en série, et un pilotage des détecteurs (4, 4a, 4'a, 4b, 4'b) de charge par réflectométrie.
